# EUROPEAN PATENT SPECIFICATION

(11) **EP 3 188 257 B1**
(45) Date of publication and mention of the grant of the patent: **15.05.2019**
(21) Application number: 16206937.1
(22) Date of filing: 27.12.2016
(51) Int. Cl.: H01L 31/05, H01L 31/0224

(54) **SOLAR CELL MODULE**
SOLARZELLENMODUL
MODULE DE CELLULE SOLAIRE

(30) Priority: 28.12.2015 KR 20150187561
(43) Date of publication of application: 05.07.2017
(73) Proprietor: LG ELECTRONICS INC., Yeongdeungpo-gu, Seoul, 07336 (KR)
(72) Inventor: KIM, Jeongshik, Seoul 08592 (KR); MOON, Kangseok, Seoul 08592 (KR); YOON, Wonki, Seoul 08592 (KR); LEE, Taeyoung, Seoul 08592 (KR); LEE, Heonmin, Seoul 08592 (KR)
(74) Representative: Katérle, Axel

(56) References cited:
- EP-A1- 2 169 725
- EP-A2- 1 484 801
- WO-A1-2016/096422
- CN-A- 101 373 796
- JP-A- 2001 135 846
- JP-A- 2005 191 116
- JP-A- 2013 211 266
- US-A1- 2011 290 298

## Description

### BACKGROUND OF THE INVENTION

### Field of the Invention

Embodiments of the invention relate to a solar cell module.

### Background of the Related Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted.

A solar cell generally includes semiconductor parts, which respectively have different conductive types, for example, a p-type and an n-type and thus form a p-n junction, and electrodes respectively connected to the semiconductor parts of the different conductive types.

When light is incident on the solar cell, a plurality of electron-hole pairs are produced in the semiconductor parts and are separated into electrons and holes by the incident light. The electrons move to the n-type semiconductor part, and the holes move to the p-type semiconductor part. Then, the electrons and the holes are collected by the different electrodes respectively connected to the n-type semiconductor part and the p-type semiconductor part. The electrodes are connected to each other using electric wires to thereby obtain electric power.

The solar cells can be electrically connected to one another by wiring.

According to the Japanese Patent Application Publication No. 2012-232320, the interconnector wiring that connects a plurality of solar cells in series was coated with a solder layer on a plurality of core surfaces in a state where a plurality of cores having a circular sectional shape are arranged in a single layer. Documents WO 2016/096422 A1, EP 1484801 A2 and EP 2169725 A1 describe solar cell modules as known in the prior art.

However, because the cores are arranged in a single layer, the shading region is relatively increased at the front surface of the solar cell where the light is incident. Because surface of the solder layer is flat and light reflected on the wiring is not scattered, it is difficult to provide again a light path to be re-incident on the solar cell module. Because the thickness of the solder layer is formed to be relatively thick, there is a problem that the manufacturing cost increases.

### SUMMARY OF THE INVENTION

An object of the invention is to provide a solar cell module.

In one aspect and in accordance with the independent claim 1, there is provided a solar cell module including a plurality of solar cells each including a semiconductor substrate and electrodes formed on a surface of the semiconductor substrate; and a plurality of wirings connected to the electrodes provided in the each solar cell through a conductive adhesive in order to electrically connect a plurality of adjacent solar cells among the plurality of solar cells. Each of the plurality of wirings includes a core bundle formed as a bundle of a plurality of cores and a conductive coating layer coating an outer surface of the core bundle, and a plurality of wiring unevenness are formed along a surface of each of the plurality of wirings in an outer surface shape of the core bundle.

The outer surface of the core bundle may be provided with core unevenness formed by the plurality of cores. The core unevenness may have recesses between the plurality of cores, and the plurality of wiring unevenness may be formed on a surface of the coating layer, and have recesses between the plurality of cores.

A maximum thickness of the coating layer may be smaller than a height or a width of the core unevenness. A maximum thickness of the coating layer may be between 1/10 and 1/2 of a height of the core unevenness formed on the outer surface of the core bundle.

A line width of each of the plurality of cores forming the outer surface of the core bundle may be between 70 µm and 160 µm, and an average thickness of the coating layer may be between 5 µm and 20 µm.

The plurality of cores may be formed of any one of copper (Cu), silver (Ag), gold (Au), and aluminum (Al), and the coating layer may be formed of tin (Sn) or an alloy containing tin (Sn).

The plurality of wiring unevenness may be formed on a surface of a first portion connected to the electrodes, and on a surface of a second portion opposite the first portion with respect to a center of the plurality of wirings in each of the plurality of wirings.

The core bundle may be formed by stacking the plurality of cores in at least three layers, and a number of the plurality of cores stacked on the first portion and the second portion may be less than a number of the plurality of cores stacked between the first portion
and the second portion.

A width of each of the plurality of wiring unevenness formed on the surface of the each of the plurality of wirings may be between 70 µm and 150 µm, and a height of each of the plurality of wiring unevenness formed on the surface of each of the plurality of wirings may be between 10 µm and 70 µm.

The plurality of cores provided in the core bundle may be elongated or twisted in a longitudinal direction of the plurality of wirings.

A cross section of each of the plurality of cores may be at least one of a circular shape, an elliptical shape, and a polygonal shape having a circular shape as a whole.

A maximum line width of each of the plurality of wirings may be between 200 µm and 500 µm.

A width of the conductive adhesive may be larger than a width of each of the plurality of wiring unevenness connected to the conductive adhesive, and smaller than a maximum line width of each of the plurality of wirings. The width of the conductive adhesive may be in a range of 320 µm to 380 µm.

The conductive adhesive may have a form of a solder paste containing tin (Sn) or a form of a conductive adhesive paste in which a plurality of conductive particles are distributed in an adhesive resin.

When the conductive adhesive has a form of a conductive adhesive paste formed by a plurality of conductive particles being distributed in an adhesive resin, the adhesive resin may be formed of at least one of an epoxy-based resin, a silicon-based resin, or an acrylic-based resin, and the conductive particles may be formed to include at least one of Ni, Ag, and SnBi.

A size of the conductive particles may be smaller than a width or a height of each of the plurality of the wiring unevenness. For example, a size of the conductive particles may be between 1 µm and 10 µm.

A melting point of the adhesive resin included in the conductive adhesive may be lower than a melting point of the coating layer included in the plurality of wirings. A curing temperature of the adhesive resin may be between 155 °C and 185 °C.

In the solar cell module according to the invention, by using the wiring having the unevenness on the outer surface, (1) the adhesion between the wirings and the electrodes can be further improved, (2) when the wirings and the electrodes, solder can be used as the conductive adhesive, and a conductive adhesive paste in which a plurality of conductive
particles are distributed in an adhesive resin can be used. The manufacturing cost can be further reduced, (3) in addition, a conductive adhesive paste which is cured at a low temperature as a conductive adhesive can be used, it is possible to minimize the buckling phenomenon in which the semiconductor substrate is bent by the thermal expansion stress during the tabbing process.

### BRIEF DESCRIPTION OF THE DRAWINGS

FIGS. 1 to 3 illustrate an example of a solar cell module applied to a solar cell according to an embodiment of the invention.
FIG. 4 is a partial perspective view illustrating an example of a solar cell applied to the solar cell module of FIG. 1.
FIG. 5 illustrates an example of a wiring applied to an example of a solar cell module according to an embodiment of the invention.
FIG. 6 illustrates a lamination structure of a core bundle forming a wiring and various cross-sectional shapes of the cores according to an embodiment of the invention.
FIG. 7 illustrates another example of a core bundle forming a wiring according to an embodiment of the invention.
FIG. 8 is an example showing an outline of a wiring according to an embodiment of the invention.
FIG. 9 illustrates an example in which a wiring according to the invention is connected to an electrode of a solar cell through a conductive adhesive.
FIG. 10 illustrates another example in which a wiring according to the invention is connected to an electrode of a solar cell through a conductive adhesive.

### DETAILED DESCRIPTION OF THE EMBODIMENTS

Reference will now be made in detail to embodiments of the invention, examples of which are illustrated in the accompanying drawings. This invention may, however, be embodied in many different forms and should not be construed as limited to the embodiments set forth herein. Wherever possible, the same reference numbers will be used throughout the drawings to refer to the same or like parts. It will be noted that a detailed description of known arts will be omitted if it is determined that the detailed description of the known arts can obscure the embodiments of the invention.

In the drawings, the thickness of layers, films, panels, regions, etc., are exaggerated for clarity. It will be understood that when an element such as a layer, film, region, or substrate is referred to as being "on" another element, it can be "directly on" the other element or intervening elements may also be present. In contrast, when an element is referred to as being "directly on" another element, there are no intervening elements present. Further, it will be understood that when an element such as a layer, film, region, or substrate is referred to as being "entirely" on other element, it may be on the entire surface of the other element and may not be on a portion of an edge of the other element.

In the following description, "front surface" of a component may be one surface of a semiconductor substrate, on which light is directly incident, and "back surface" of a component may be a surface opposite the one surface of the semiconductor substrate, on which light is not directly incident or reflective light may be incident.

In the following description, the fact that a thickness or a width of a component is equal to a thickness or a width of another component indicates that they have the same value within a margin of error of 10 % including a process error.

Then, with reference to the accompanying drawings, a solar cell module according to an embodiment of the invention is described.

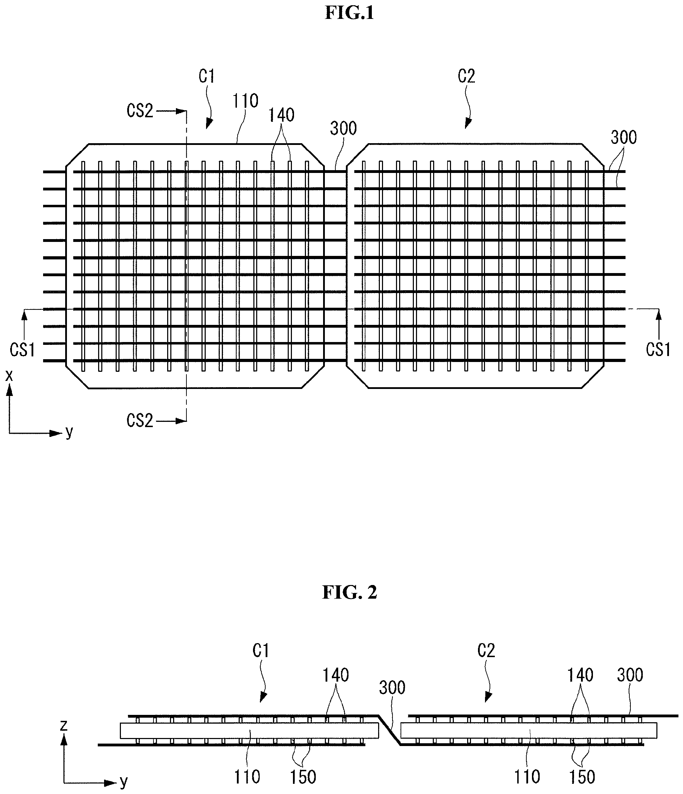

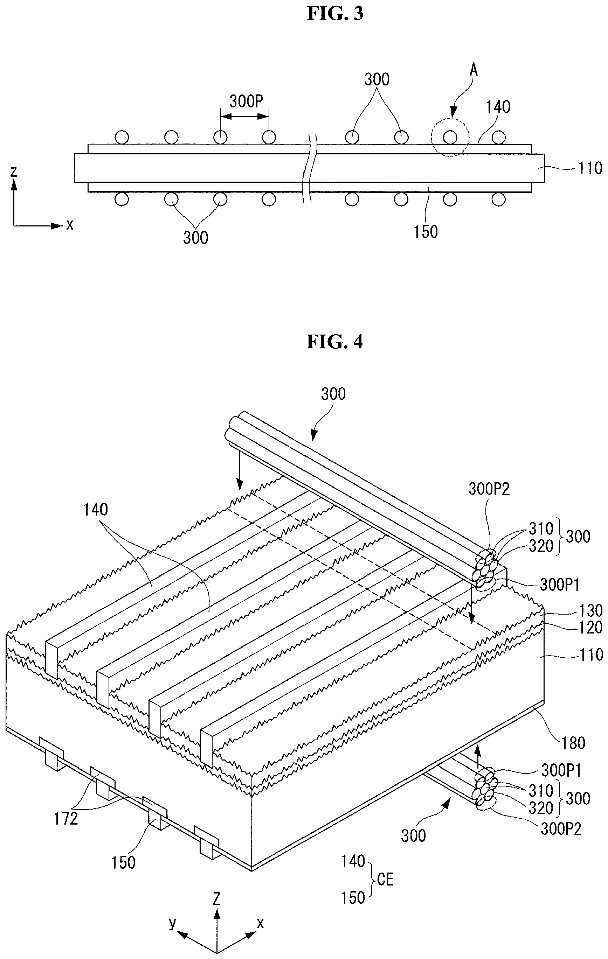

FIGS. 1 to 3 illustrate an example of a solar cell module applied to a solar cell according to an embodiment of the invention. In this instance, FIG. 1 illustrates a solar cell module viewed from a front. FIG. 2 is a cross-sectional view along line CS1-CS1 in FIG. 1. FIG. 3 is a cross-sectional view along line CS2-CS2 in FIG. 1. FIG. 4 is a partial perspective view illustrating an example of a solar cell according to an embodiment of the invention applied to FIG. 1.

As shown in FIGS. 1 to 3, the solar cell according to an embodiment of the invention may include a plurality of solar cells C1 and C2 and a plurality of wirings 300 which are connected to each of the plurality of solar cells C1 and C2.

A first solar cell C1 and a second solar cell C2 may include a first electrode 140 on a front surface of a semiconductor substrate 110 and a second electrode 150 on a back surface of the semiconductor substrate 110.

The first and second electrodes 140 and 150 of each of the first and second solar cells C1 and C2 may be elongated in a stripe shape in a first direction x.

The first and second solar cells C1 and C2 may be arranged in a second direction y intersecting the first direction x, and may be electrically connected to each other by a plurality of wirings 300 extending in the second direction y.

For example, each of the plurality of wirings 300 may be connected to the first electrode 140 of the first solar cell C1 and the second electrode 150 of the second solar cell C2, and serve as an interconnector which connects the first and second solar cells C1 and C2 in series with each other.

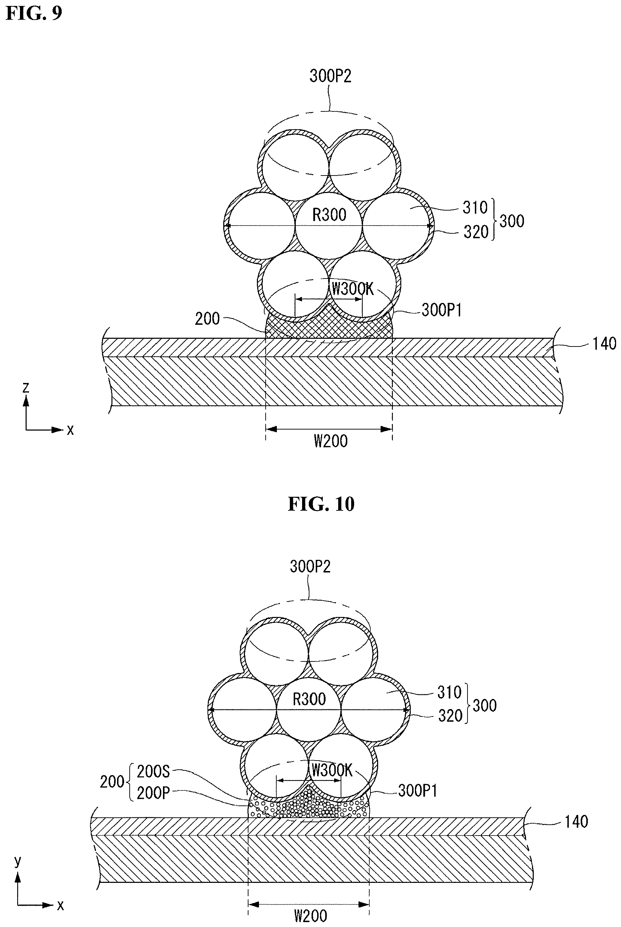

In FIG. 1 and FIG. 2, when the plurality of wirings 300 are connected to the first electrode 140 and the second electrode 150 of each solar cell, they may be connected through a conductive adhesive. A configuration in which the plurality of wirings 300 are connected to the electrodes of the respective solar cells through the conductive adhesive is described in more detail with reference to FIGS. 9 and 10.

In this instance, the number of the plurality of wirings 300 may be 6 to 33 based on one surface of the solar cell. In addition, a maximum line width of each of the plurality of wirings 300 may be between 200 µm and 500 µm.

For example, when the line width of the wirings 300 is 200 µm or more and less than 300 µm, the number of wirings 300 may be 15 to 33. In addition, when the line width of the wirings 300 is 300 µm or more and less than 350 µm, the number of the wirings 300 may be 10 to 15. When the line width of the wirings 300 is 350 µm or more and less than 400 µm, the number of the wirings 300 may be 8 to 10. When the line width of the wirings 300 is 400 µm to 500 µm, the number of the wirings 300 may be 6 to 8.

As described below, by arranging the number of wirings 300 differently according to the line width of the wirings 300, while preventing the total shading area covered by the wirings 300 from increasing on the light receiving surface of the solar cell, the self-resistance of the wirings 300 can be appropriately adjusted. Thus, the output reduced by the wirings 300 can be minimized, and the output of the solar cell module can be further improved.

The relationship between the number of wirings 300 according to the line width described above is only one example optimized, and the invention is not necessarily limited thereto.

Further, as shown in FIG. 3, the wirings 300 are commonly connected to the first electrode 140 or the second electrode 150. A pitch 300P between the two wirings 300 adjacent to each other may be set to be between 4.75 mm and 25.13 mm in consideration of the line width and the number of the wirings 300 and the shading area of the wirings 300.

In addition, in FIGS. 1 and 2, described is an instance that the wirings 300 which is connected to the first electrode 140 of the first solar cell C1 through a conductive adhesive is directly connected to the second electrode 150 through a conductive adhesive. Alternatively, however, a separate interconnector, which extends in a first direction x, may be provided between the first solar cell and the second solar cell. The wirings 300 connected to the first electrode 140 of the first solar cell C1 through the conductive adhesive and the wirings 300 connected to the second electrode 150 of the second solar cell through the conductive adhesive are commonly connected to the separate interconnectors. Thus, the first solar cell and the second solar cell may be connected in series.

In this instance, as shown in FIG. 4, an example of a solar cell applied to the solar cell module according to the invention may include a semiconductor substrate 110, an emitter region 120, an anti-reflection layer 130, a first electrode 140, a back surface field (BSF) region 172, a back passivation layer 180, and a second electrode 150.

The semiconductor substrate 110 may have a first conductivity type, for example, a p-type or an n-type conductivity type. The semiconductor substrate 110 may be formed of any one of single crystal silicon, polycrystalline silicon, and amorphous silicon. For example, the semiconductor substrate 110 may be formed of a crystalline silicon wafer. However, the semiconductor substrate 110 is not necessarily limited to such a silicon wafer. A GaAs substrate may be used as the semiconductor substrate 110.

Specifically, when the semiconductor substrate 110 has a p-type conductivity type, the semiconductor substrate 110 may be doped with impurities of a group III element, such as boron, gallium, indium, and the like. Alternatively, however, the semiconductor substrate 110 may be of an n-type conductivity type. When the semiconductor substrate 110 has an n-type conductivity type, the semiconductor substrate 110 may be doped with impurities of a group V element, such as phosphorus (P), arsenic (As), and antimony (Sb).

A front surface of the semiconductor substrate 110 has a plurality of uneven surfaces. For convenience, in FIG. 4, although only an edge portion of the semiconductor substrate 110 is shown as the plurality of uneven surfaces, an entire front surface of the semiconductor substrate 110 substantially has the plurality of uneven surfaces. Thus, the emitter region 120 and the anti-reflection layer 130 located on the front surface of the semiconductor substrate 110 may have the plurality of uneven surfaces.

As shown in FIG. 4, the emitter region 120 may be formed on the front surface, incidence surface, of the semiconductor substrate 110 of the first conductivity type. The emitter region 120 may be located inside the front surface, which is a light incidence surface as a region where a second conductive type opposite the first conductive type, for example, an n-type conductive type type impurity is doped into the semiconductor substrate 110, of the semiconductor substrate 110. Thus, the emitter region 120 of the second conductivity type may form a p-n junction with the first conductive type portion of the semiconductor substrate 110.

The light incident on the semiconductor substrate 110 is separated into electrons and holes, so that the electrons may move toward the n-type and the holes may move toward the p-type. Accordingly, when the semiconductor substrate 110 is p-type and the emitter region 120 is n-type, the separated holes may move toward the back surface of the semiconductor substrate 110, and the separated electrons may move toward the emitter region 120.

Since the emitter region 120 forms a p-n junction with the semiconductor substrate 110, that is, the first conductive portion of the semiconductor substrate 110, unlike the embodiment, when the semiconductor substrate 110 has an n-type conductivity type, the emitter region 120 may have a p-type conductivity type. In this instance, the separated electrons may move toward the back surface of the semiconductor substrate 110, and the separated holes may move toward the emitter region 120.

When the emitter region 120 has an n-type conductivity type, the emitter region 120 may be formed by the semiconductor substrate 110 being doped with impurities of a group V element. Conversely, when the emitter region 120 has a p-type conductivity type, the emitter region 120 may be formed by the semiconductor substrate 110 being doped with impurities of a group III element.

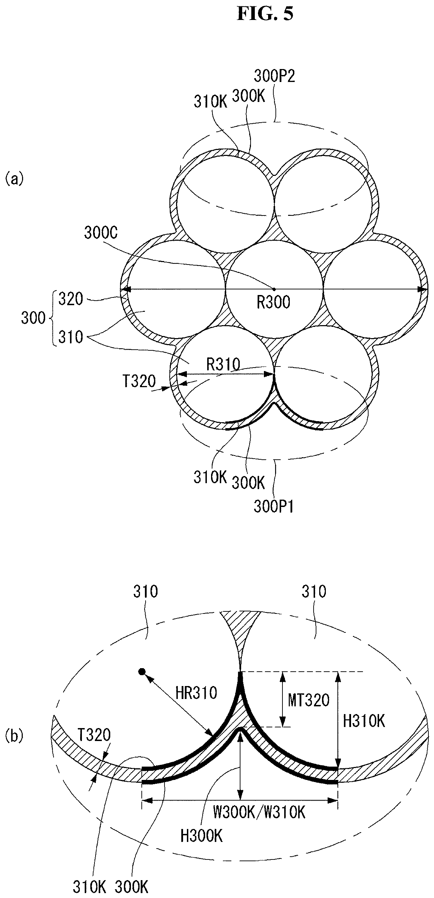

The anti-reflection layer 130 is located on an incident surface of the semiconductor substrate 110. As shown in FIGS. 4 and 5, when the emitter region 120 is located on the incident surface of the semiconductor substrate 110, the anti-reflection layer 130 may be disposed on the emitter region 120.

The anti-reflection layer 130 may be formed of a plurality of layers of at least one of a hydrogenated silicon nitride layer (SiNx: H), a hydrogenated silicon oxide layer (SiOx: H), a hydrogenated silicon nitride oxide layer (SiNxOy: H), and a hydrogenated amorphous silicon (a-Si: H).

Accordingly, passivation function of the anti-reflection layer 130 can be further enhanced and photoelectric efficiency of the solar cell can be further improved.

The plurality of first electrodes 140 are located on the front surface of the semiconductor substrate 110 as shown in FIG. 4, and are spaced apart from each other on the front surface of the semiconductor substrate 110, each of which can be extended in the first direction x.

In this instance, the plurality of first electrodes 140 may be electrically connected to the emitter region 120 through the anti-reflection layer 130.

Accordingly, the plurality of first electrodes 140 can collect charges, for example, electrons, which have moved toward the emitter region 120.

The back surface field region 172 may be located on a back surface opposite the front surface of the semiconductor substrate 110. The back surface field region 172 may be a region (for example, a p⁺-type region) which is more heavily doped than the semiconductor substrate 110 with impurities of the same first conductive type as the semiconductor substrate 110.

The back surface field region 172 may be formed in a long direction in the first direction x by overlapping with the second electrode 150 pattern to be described later, and formed in a plurality of lines spaced apart in the second direction y. Thus, the back surface field region 172 may be comprised of a plurality of the back surface field region lines 172.

A potential barrier is formed due to the difference in impurity concentration between the semiconductor substrate 110 and the back surface field region 172. Therefore, while preventing the movement of the electrons toward the back surface field region 172, which is the direction of the movement of the holes, it is possible to facilitate the movement of the holes toward the back surface field region 172.

Thus, an amount of charge movement toward the second electrode 150 can be increased by reducing the amount of charge lost due to the recombination of electrons and holes in the back surface and the vicinity of the semiconductor substrate 110 and accelerating the movement of the desired charges, for example, holes.

The back passivation layer 180 may be formed to cover an entire back surface of the semiconductor substrate 110 except a portion where the second electrode 150 is formed, and perform a passivation function and an insulation function for the back surface of the semiconductor substrate 110. The back passivation layer 180 may be formed of at least one layer of silicon nitride (SiNx), silicon oxide (SiO), or silicon oxynitride (or silicon nitride oxide) (SiNxOy).

The second electrodes 150 may be formed in parallel with each other in the first direction x on the back surface opposite the one surface of the semiconductor substrate 110, and may be spaced apart in the second direction y that intersects the first direction x.

The second electrode 150 may collect electric charges, for example, holes, moving from the back surface field region 172 by overlapping with and being electrically connected to the back surface field region 172.

In this instance, since the second electrode 150 is in contact with the back surface field region 172 which maintains a higher impurity concentration than the semiconductor substrate 110, contact resistance between the back surface field region 172 and the second electrode 150 decreases. Therefore, the charge transfer efficiency from the semiconductor substrate 110 to the second electrode 150 can be improved.

Since the wiring 300 is connected to the second electrode 150, charges (e.g., holes) collected on the second electrode 150 can be transferred to adjacent other solar cells through the wiring 300.

The first electrode 140 and the second electrode 150 may include a metal material having good conductivity, and contain at least one conductive material such as, for example, silver (Ag).

Further, in FIG. 4, patterns of the first electrode 140 and the second electrode 150 are formed to extend in the first direction x. However, unlike FIG. 4, the patterns of the first electrode 140 and the second electrode 150 may be differently provided.

For example, the first electrode 140 and the second electrode 150 may be formed in a pattern in which other electrodes extending long in the second direction y are connected to electrodes extending long in the first direction x.

In this instance, the other electrodes extending in the second direction y may overlap with the wiring 300. Alternatively, unlike the above, the second electrode 150 may be provided in a form of a surface electrode covering the entire back surface of the semiconductor substrate 110. As described above, the first electrode 140 and the second electrode 150 may be provided in various patterns

As shown in FIG. 4, each of the plurality of wirings 300 for connecting a plurality of solar cells to each other in series through a conductive adhesive may be connected in a long length in the second direction y. In FIG. 4, showing of the conductive adhesive is omitted. However, this will be described in detail in FIG. 9 and FIG. 10.

Each of the plurality of wirings 300 connected to the electrodes 140, 150 of each solar cell in the solar cell module according to the invention may include a core bundle which is formed as a bundle of a plurality of conductive cores 310 and a conductive coating layer 320. A plurality of wiring unevenness may be formed on a surface of each of the plurality of wirings. This will be described in more detail with reference to FIG. 5 below.

FIG. 5 illustrates an example of a wiring 300 applied to an example of a solar cell module according to the invention.

In FIG. 5, (a) is a cross-sectional view of the wiring 300, and in FIG. 5, (b) is an enlarged view of a portion of the wiring 300 shown in (a) of FIG. 5.

As shown in (a) and (b) of FIG. 5, an interconnection wiring 300 according to the invention may include a core bundle 310 and a conductive coating layer 320.

In this instance, the core bundle may be formed as a bundle of a plurality of conductive cores 310. The plurality of conductive cores 310 have a relatively low resistance, while minimizing current loss, and may function to transfer carriers generated in each solar cell to adjacent other solar cells.

The material of the core 310 may be any one of copper (Cu), silver (Ag), gold (Au), or aluminum (Al).

The coating layer 320 may be coated on an outer surface of the core bundle. In addition, as shown in (a) of FIG. 5, the coating layer 320 may fill a space between the plurality of conductive cores 310 in the core bundle as well as the outer surface of the core bundle.

The coating layer 320 may be formed of tin (Sn) or an alloy containing tin (Sn), be formed such that the plurality of conductive cores 310 included in the core bundle is formed as a bundle, coat the surfaces of the plurality of conductive cores 310, and prevent oxidation of the core 310. When the wiring 300 is connected to the electrodes 140 and 150 of the solar cell through a conductive adhesive, the coating layer 320 may function to secure the adhesive force between the core bundle and the conductive adhesive.

The interconnection wiring 300 including the core bundle and the conductive coating layer 320 may include a plurality of wiring unevenness 300K bent along the outer shape of the core bundle on the surface of each of the plurality of wirings 300.

In this instance, the outer surface of the core bundle refers to the outer surface of the core bundle when viewed from the outside of the core bundle formed as a bundle of the plurality of conductive cores 310.

As described above, since the wiring 300 according to the invention has a plurality of wiring unevenness 300K bent on the surface of the conductive coating layer 320 along the outer surface shape of the core bundle, the following effects can be expected.

First, unevenness is formed in a first portion 300P1 connected to the electrode in the wiring 300. Thus, a surface area of a portion connected to the electrode in the wiring 300 can be increased. Accordingly, adhesion between the wiring 300 and the electrodes 140 and 150 can be further improved.

In addition, second, the wiring unevenness 300K is formed in a second portion 300P2 where light is incident on the wiring 300. Thus, the light incident on the wiring 300 may be diffused and re-incident into the solar cell. Accordingly, the optical effect of the solar cell module can be further improved, and the efficiency of the solar cell module can be further improved.

In this instance, division of the first and second portions 300P1 and 300P2 can be determined based on the wiring 300 connected to the electrodes 140 and 150 of the solar cell. For example, as shown in FIGS. 1 to 4, when the wiring 300 is disposed, a lower portion of the wiring 300 may be connected to the first electrode 140 of the first solar cell C1, and an upper portion of the wiring 300 may be connected to the second electrode 150 of the second solar cell C2.

Therefore, the lower portion of the wiring 300 connected to the first solar cell C1 can be defined as the first portion 300P1 of the wiring 300 and the upper portion of the wiring 300 can be defined as the second portion 300P2 of the wiring 300. In the second solar cell C2, the upper portion of the wiring 300 can be defined as the first portion 300P1 of the wiring 300 and the lower portion can be defined as the second portion 300P2 of the wiring 300.

The outer surface shape of the core bundle may, as shown in (b) of FIG. 5, include a core unevenness 310K formed by a plurality of cores 310. The core unevenness 310K is depressed (recessed or have recesses) between a plurality of cores 310 forming the outer surface of the core bundle. A plurality of wiring unevenness 300K formed on the surface of the wiring 300 may be depressed (recessed or have recesses) between the plurality of cores 310.

That is, the core unevenness 310K refers to unevenness formed on the outer surface of the core bundle formed by the plurality of cores 310. The wiring unevenness 300K refers to unevenness formed on the surface of the conductive coating layer 320 coated on an outer surface of the core bundle.

In addition, the outer surface of the core bundle refers to an outer surface of the core bundle formed of the plurality of conductive cores 310.

As shown in (a) and (b) of FIG. 5, the outer surface of the core bundle can be depressed (recessed or have recesses) toward a center of the wiring 300 between the plurality of cores 310. That is, as shown in FIG. 5, when the cross section of each core 310 is circular, due to the shape of the core 310 having a circular cross section, as becoming closer to a portion where the plurality of cores 310 are in contact with each other, the core unevenness 310K in which the outer surface of the core bundle is depressed (recessed or have recesses) toward the center can be formed.

In addition, when the coating layer 320 is formed on the core unevenness 310K, the wiring unevenness 300K refers to unevenness formed on the surface of the coating layer 320. As shown in (a) and (b) of FIG. 5, the wiring unevenness 300K may be formed in the coating layer 320 along the shape of the core unevenness 310K. Therefore, the wiring unevenness 300K can be depressed (recessed or have recesses) between the plurality of cores 310.

Even if the wiring 300 includes the core bundle formed as the bundle of the plurality of cores 310, if the thickness of the coating layer 320 is relatively large, even if the outer surface of the core bundle is provided with unevenness, due to the relatively thick coating layer 320, the surface of the wiring 300 may have a flat surface without forming the wiring unevenness 300K. In such an instance, it may be difficult to expect an increase in surface area of the wiring 300 and an optical effect of the wiring 300 at a portion connected to the electrode as described above.

However, in the wiring 300 according to the invention, the thickness of the coating layer 320 coated on the outer surface of the core bundle is made sufficiently thin, and wiring unevenness 300K is formed on the surface of the wiring 300. Therefore, the increase in surface area of the wiring 300 and the optical effect of the wiring 300 as described above can be expected.

In this instance, the increase in the surface area of the wiring 300 and the optical effect of the wiring 300 can be further optimized by a size of the wiring unevenness 300K formed on the surface of the wiring 300. The size of the wiring unevenness 300K may be affected by a line width of the core 310, a size of the core unevenness 310K, and a thickness of the coating layer 320. Detailed descriptions thereof will be described below.

As described above, in order for a shape of the core unevenness 310K to be the same or similar to that of the wiring unevenness 300K, a maximum thickness MT320 of the coating layer 320 may be smaller than a height H310K of the core unevenness 310K or a width W310K of the core unevenness 310K.

Preferably, the maximum thickness MT320 of the coating layer 320 may be between 1/10 and 1/2 of the height H310K of the core unevenness 310K forming the outer surface of the core bundle.

As shown in (a) and (b) of FIG. 5, when the plurality of cores 310 provided in the core bundle are formed in contact with each other, the height H310K of the core unevenness 310K may be equal to a radius HR310 of the core 310, and the width W310K of the core unevenness 310K may be equal to a diameter R310 of the core 310 (i.e., a line width of the core 310).

The maximum thickness MT320 of the coating layer 320 may be a thickness from the interface between the two cores 310 to the surface of the coating layer 320.

However, as shown in (a) and (b) of FIG. 5, when the plurality of cores 310 are not formed in contact with each other in the core bundle, unlike (a) and (b) of FIG. 5, a plurality of cores 310 forming an outer surface of the core bundle in the core bundle are formed spaced apart, when it is difficult to define the core unevenness 310K, and the maximum thickness MT320 of the coating layer 320 may be between 1/10 and 1/2 of a core radius HR310 forming the outer surface of the core bundle.

More specifically, when a maximum line width R300 of the wiring 300 formed by the core bundle and the coating layer 320 is between 200 µm and 500 µm, for example, the line width R310 of the core 310 (or the diameter R310 of the core 310) forming the outer surface of the core bundle may be between 70 µm and 160 µm, and the maximum thickness MT320 of the coating layer 320 may be between 7 µm and 80 µm.

In addition, an average thickness T320 of the coating layer 320 may be between 5 µm and 20 µm. In order to prevent oxidation of the core 310, and in order for a plurality of cores 310 to form a core bundle as a bundle, the average thickness T320 of the coating layer 320 may be 5 µm or more. In order to form the wiring unevenness 300K on the surface of the coating layer 320 in a curved shape along the outer surface shape of the core bundle on the surface of the coating layer 320, and in order to minimize formation cost of the coating layer 320, the average thickness T320 of the coating layer 320 may be less than 20 µm.

Since the average thickness T320 of the coating layer 320 coated on the outer surface of the core bundle is relatively small compared to the line width R310 of the core 310, a width W310K of the core unevenness 310K may substantially be the same as a width W300K of the wiring unevenness 300K.

For example, the width W300K of the wiring unevenness 300K formed on the surface of the wiring 300 may be between 70 µm and 150 µm, and a height H300K of the wiring unevenness 300K formed on the surface of the wiring 300 may be between 10 µm and 70 µm.

As described above, by forming the wiring unevenness 300K on the surface of the wiring 300 in the numerical range as described above, the surface area and the optical effect of the wiring 300 bonded to the electrodes 140 and 150 can be optimally secured.

Accordingly, each of the plurality of wirings 300 may include the wiring unevenness 300K on the surface of the first portion 300P1 connected to the electrodes, and the wiring unevenness 300K on the surface of the second portion 300P2 opposite the first portion 300P1 with respect to the center of the wiring 300.

The wiring unevenness 300K is formed on the surface of the first portion 300P1 of the wiring 300, and the surface area of the first portion 300P1 connected to the electrodes 140 and 150 is increased. Thus, the adhesion between the wiring 300 and the electrodes 140 and 150 can be further improved. The wiring unevenness 300K is formed on the surface of the second portion 300P2 of the wiring 300, and light incident on the second portion 300P2 of the wiring 300 is reflected. Thus, the light can be re-incident on the solar cell. Therefore, the efficiency of the solar cell module can be further improved.

Until now, in the wiring 300 according to the invention, it is described in the instance that the cross section of the core 310 constituting the core bundle is circular. Alternatively, the cross section of the core 310 may have a different shape. In addition, the sizes of the plurality of cores 310 in the core bundle may be different from each other. The number of cores 310 stacked on the core bundle may be different from that described above.

Hereinafter, such will be described in more detail.

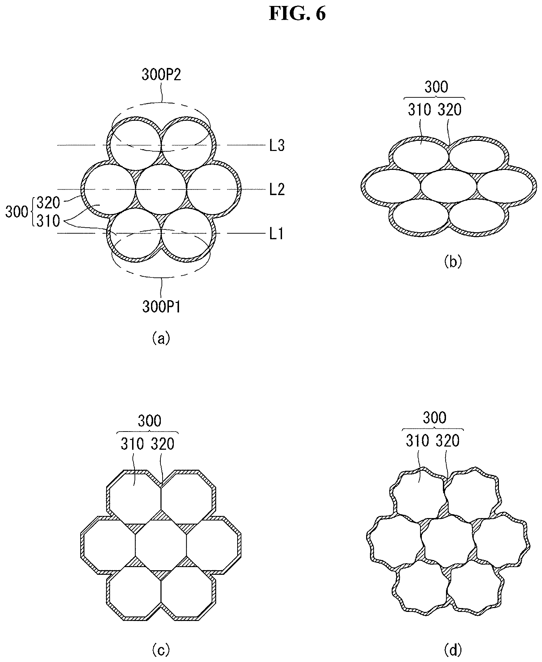

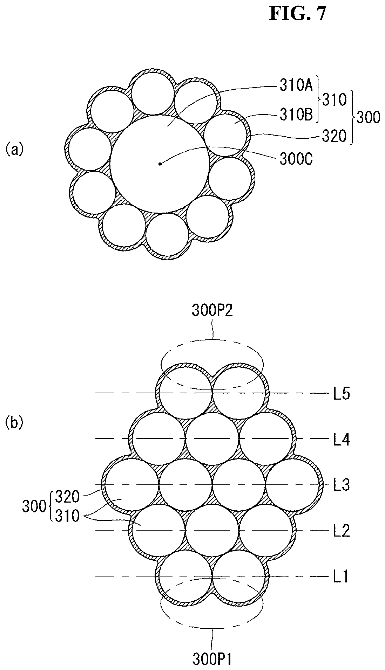

FIG. 6 illustrates a lamination structure of a core bundle forming a wiring and various cross-sectional shapes of the cores according to the invention. FIG. 7 illustrates another example of a core bundle forming a wiring according to the invention.

In the wiring 300 according to the invention, the core bundle is formed by stacking a plurality of cores 310 in at least three layers. The number of the cores 310 stacked on the first portion 300P1 and the second portion 300P2 may be less than the number of the cores 310 stacked between the first portion 300P1 and the second portion 300P2.

For example, as shown in (a) to (d) of FIG. 6, the plurality of cores 310 forming the core bundle are formed by stacking three layers. The number of the cores 310 stacked on the first portion 300P1 and the second portion 300P2, that is, the number of cores 310 provided in a first layer L1 and a third layer L3 may be two. The number of the cores 310 stacked between the first and second portions 300P1 and 300P2, that is, the number of the cores 310 provided in a second layer L2 may be three, which is more than two.

In this instance, the center of the core 310 provided in the second layer L2 may be staggered with the center of the core 310 provided in the first layer L1 and the third layer L3. Accordingly, as a space formed between the cores 310 in the core bundle is minimized, and as the overall volume of the core bundle is reduced, the core bundles can be formed more firmly.

In this instance, each core 310 forming the core bundle may have the same diameter. In this instance, as shown in (a) of FIG. 6, the cross section of each core 310 may be circular.

Alternatively, however, as shown in (b) of FIG. 6, the cross section of each core 310 may be elliptical. As shown in (c) of FIG. 6, the cross section of each core 310 may be hexagonal. In addition, as shown in (d) of FIG. 6, the cross section of each core 310 may be a polygon having a circular shape as a whole.

In addition, in (a) to (d) of FIG. 6, the cores 310 forming the core bundle have the same diameter. Alternatively, however, as shown in (a) of FIG. 7, the diameter of the core 310 may be formed differently. As shown in (b) of FIG. 7, the plurality of cores 310 forming the core bundle may be formed by stacking five layers L1 to L5.

More specifically, as shown in (c) of FIG. 7, a core bundle according to the invention is formed such that a diameter of a core 310A located at a center 300C of the wiring 300 may be larger than a diameter of a core 310B, that is, a core located outside the core bundle, forming the outer surface of the core bundle.

In addition, in the core bundle according to the invention, as shown in (b) of FIG. 7, a plurality of cores 310 forming core bundles are formed by stacking five layers L1 to L5. The number of cores 310 of the first layer L1 located in the first portion 300P1 of the wiring 300 and the fifth layer L5 located in the second layer 300P2 of the wiring 300 may be the smallest at two, but other numbers are possible. The number of the cores 310 of the third layer L3 located in the middle may be the largest at four, but other numbers are possible.

When the core bundle is formed as shown in FIG. 7, compared with FIG. 6, the size of the unevenness formed on the outer surface of the wiring 300 can be made finer, and the diffused reflection can be further increased in the second portion 300P2 of the wiring 300. Therefore, the optical effect of the wiring 300 can be further increased.

Until now, only the cross sectional shape of the wiring 300 formed of the core bundle and the coating layer 320 has been described. Hereinafter, however, an external shape of the wiring 300 will be described.

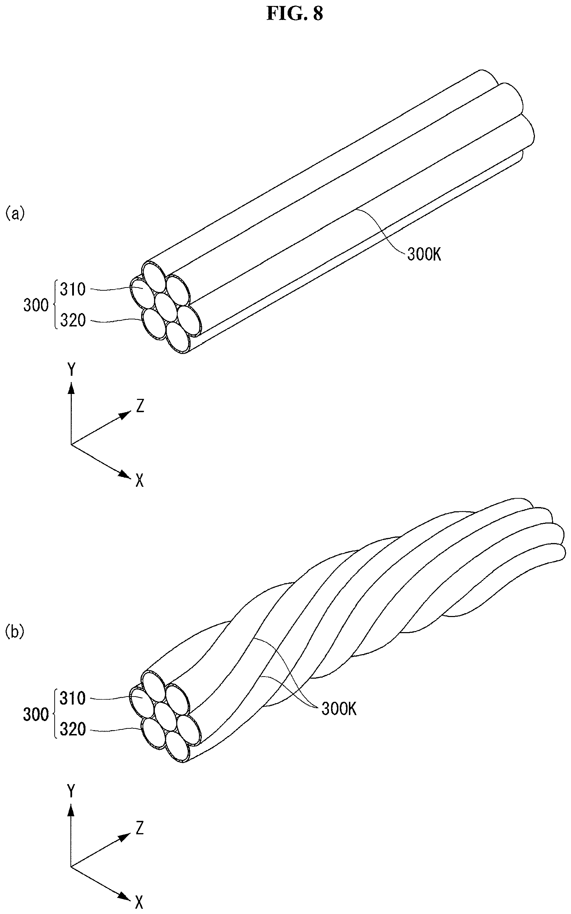

FIG. 8 is an example showing an outline of a wiring 300 according to the invention.

As shown in (a) of FIG. 8, a plurality of cores 310 provided in a core bundle according to the invention may be elongated in a longitudinal direction of a wiring 300.

In this instance, as shown in (a) of FIG. 8, a wiring unevenness 300K formed on an outer surface of the wiring 300 may have a groove shape extending long in the longitudinal direction z of the wiring 300.

Alternatively, as shown in (b) of FIG. 8, in a wiring 300 according to the invention, a plurality of cores 310 provided in the core bundle may be twisted in a longitudinal direction z and an oblique direction of the wiring 300.

In this instance, as shown in (b) of FIG. 8, a wiring unevenness 300K formed on the outer surface of the wiring 300 may have a groove shape that rotates along an outer surface of the wiring 300 in the longitudinal and oblique directions of the wiring 300.

The wiring 300 according to the invention may be connected to the first electrode 140 or the second electrode 150 formed on the semiconductor substrate 110, as shown in FIG. 3.

In FIGS. 9 and 10, a structure in which a wiring 300 of the invention is connected to an electrode will be described in more detail below.

FIG. 9 illustrates an example in which the wiring 300 according to the invention is connected to an electrode of a solar cell through a conductive adhesive. FIG. 10 illustrates another example in which the wiring 300 according to the invention is connected to an electrode of a solar cell through a conductive adhesive.

In FIGS. 9 and 10, the wiring 300 is connected to the first electrode 140 of the solar cell. However, the wiring 300 may also be connected to the second electrode 150 of the solar cell.

In addition, in FIGS. 9 and 10, the wiring 300 is connected to the electrodes 140 and 150 through the conductive adhesive 200. However, the wiring 300 and the semiconductor substrate 110 may be bonded to each other through the conductive adhesive 200 in a region of the semiconductor substrate 110 where the wiring 300 and the electrodes 140 and 150 are not overlapped.

As shown in FIG. 9, the wiring 300 may be connected to the electrodes 140 and 150, for example, the first electrode 140, of the solar cell through the conductive adhesive 200. In this instance, a material of the conductive adhesive 200 may be, for example, in a form of a solder paste containing tin (Sn) or tin (Sn) alloy.

In this instance, a width W200 of the conductive adhesive 200 may be larger than the first portion 300P1 of the wiring 300, that is, the width W300K of the wiring unevenness 300K formed in a portion connected to the conductive adhesive 200. The width W200 of the conductive adhesive 200 may be smaller than the maximum line width R300 (or diameter) of the wiring 300. In this instance, the width W200 of the conductive adhesive 200 may refer to a width in a line width direction x of the wiring 300, that is, in a first direction x.

The width W200 of the conductive adhesive 200 is formed to be larger than the width W300K of the wiring unevenness 300K formed in the first portion 300P1 of the wiring 300. Thus, the wiring 300 and the electrodes 140 and 150 can have sufficient adhesion and low contact resistance. In addition, the width W200 of the conductive adhesive 200 is formed to be smaller than the maximum line width R300 of the wiring 300. Thus, a shading area where the semiconductor substrate 110 is covered with the conductive adhesive 200 can be minimized.

For example, when the maximum line width R300 of the wiring 300 is formed to be 380 µm to 480 µm, the width W200 of the conductive adhesive 200 can be formed in a range, for example, a range of 320 µm to 380 µm, larger than the width W300K of the wiring unevenness 300K and less than the maximum line width R300 of the wiring 300.

In FIG. 9, described is the instance where the conductive adhesive 200 has a solder paste shape as an example. Alternatively, as shown in FIG. 10, the conductive adhesive 200 may be a form of a conductive adhesive paste in which a plurality of conductive particles 200P are distributed in an adhesive resin 200S.

In this instance, the adhesive resin 200S of the conductive adhesive 200 may be formed of at least one of an epoxy-based resin, a silicon-based resin, or an acrylic-based resin. The conductive particles 200P may be formed to include at least one of Ni, Ag, or SnBi.

In this instance, a size of the conductive particles 200P may be smaller than the width W300K or the height H300K of the wiring unevenness 300K. For example, the size of the conductive particles 200P may be between 1 µm and 10 µm. Reference to the size of the conductive particles 200P may refer to a diameter of the conductive particles 200P, which may be a maximum diameter, an average diameter, or another type of measurement of the conductive particles 200P.

The adhesive resin 200S of the conductive adhesive 200 can sufficiently secure the physical adhesion force between the wiring 300 and the electrodes 140 and 150, and the physical adhesion force between the wiring 300 and the semiconductor substrate 110.

In addition, during a tabbing process for connecting the wiring 300 to the solar cell, the wiring unevenness 300K formed in the first portion 300P1 of the wiring 300 hold the conductive particles 200P in the adhesive resin 200S so as not to be deviated toward the outside of the wiring 300. The conductive particles 200P are stably positioned between the wiring unevenness 300K and the electrodes 140 and 150. Therefore, the contact resistance between the wiring 300 and the electrodes 140 and 150 can be made sufficiently low.

A curing temperature of the adhesive resin 200S included in the conductive adhesive 200 may be lower than a melting point of the coating layer 320 included in the wiring 300.

Thus, according to the embodiments of the invention, the curing temperature of the adhesive resin 200S is set to be lower than that of the coating layer 320 of the wiring 300. The wiring unevenness 300K formed on the surface of the first portion 300P1 of the wiring 300 during the tabbing process can be maintained in its shape. Thus, as described above, the conductive particles 200P of the conductive adhesive 200 during the tabbing process are prevented from being deviated toward the outside of the wiring 300. Therefore, a sufficiently low contact resistance can be provided between the wiring 300 and the electrodes 140 and 150.

In this instance, the curing temperature of the adhesive resin 200S may be, for example, between 155 °C and 185 °C. As described above, according to the invention, the curing temperature of the adhesive resin 200S of the conductive adhesive 200 is sufficiently low. Thus, the temperature of the tabbing process can be lowered. It is possible to prevent the semiconductor substrate 110 from buckling due to the thermal expansion stress of the wiring 300 or the electrodes 140 and 150 during the tabbing process.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A solar cell module, comprising:
a plurality of solar cells (C1, C2) each including a semiconductor substrate (110) and electrodes (140, 150) formed on a surface of the semiconductor substrate; and
a plurality of wirings (300) connected to the electrodes provided in each solar cell through a conductive adhesive (200) in order to electrically connect a plurality of adjacent solar cells among the plurality of solar cells,
**characterized in that** each of the plurality of wirings includes a core bundle (310) formed as a bundle of a plurality of cores and a conductive coating layer (320) coating an outer surface of the core bundle, and
wherein a plurality of wiring unevennesses (300K) are formed along a surface of each of the plurality of wirings in an outer surface shape of the core bundle.

2. The solar cell module of claim 1, wherein the outer surface of the core bundle (310) is provided with a core unevenness (310K) formed by the plurality of cores,
wherein the core unevenness comprises recesses between the plurality of cores, and
wherein the plurality of wiring unevennesses (300K) are formed on a surface of the conductive coating layer (320), and comprise recesses between the plurality of cores.

3. The solar cell module of claim 2, wherein a maximum thickness (MT320) of the conductive coating layer (320) is smaller than a height (H310K) or a width (W310K) of the core unevenness (310K), and is preferably between 1/10 and 1/2 of the height of the core unevenness formed on the outer surface of the core bundle (310).

4. The solar cell module of claim 2 or 3, wherein a line width (R310) of each of the plurality of cores forming the outer surface of the core bundle is between 70 µm and 160 µm, and
wherein an average thickness (T320) of the conductive coating layer (320) is between 5 µm and 20 µm.

5. The solar cell module of any one preceding claim, wherein the plurality of cores are formed of any one of copper (Cu), silver (Ag), gold (Au), and aluminum (Al), and
wherein the conductive coating layer (320) is formed of tin (Sn) or an alloy containing tin (Sn).

6. The solar cell module of any one preceding claim, wherein the plurality of wiring unevennesses (300K) are formed on a surface of a first wiring portion (300P1) connected to the electrodes (140, 150), and on a surface of a second wiring portion (300P2) opposite the first wiring portion with respect to a center of the plurality of wirings (300) in each of the plurality of wirings.

7. The solar cell module of claim 6, wherein the core bundle (310) is formed by stacking the plurality of cores in at least three layers, and
wherein the number of the plurality of cores stacked on the first wiring portion (300P1) and the second wiring portion (300P2) is less than the number of the plurality of cores stacked between the first wiring portion and the second wiring portion.

8. The solar cell module of any one preceding claim, wherein a width (W300K) of each of the plurality of wiring unevennesses (300K) formed on the surface of each of the plurality of wirings is between 70 µm and 150 µm, and
wherein a height (H300K) of the each of the plurality of wiring unevennesses formed on the surface of each of the plurality of wirings is between 10 µm and 70 µm.

9. The solar cell module of any one preceding claim, wherein the plurality of cores provided in the core bundle (310) are elongated or twisted in a longitudinal direction of the plurality of wirings (300); and/or wherein a cross section of each of the plurality of cores is one of a circular shape, an elliptical shape, and a polygonal shape having a circular outline.

10. The solar cell module of any one preceding claim, wherein a maximum line width of each of the plurality of wirings (300) is between 200 µm and 500 µm.

11. The solar cell module of any one preceding claim, wherein a width (W200) of the conductive adhesive (200) is larger than a width (W300K) of each of the plurality of wiring unevennesses (300K) connected to the conductive adhesive, and smaller than a maximum line width of each of the plurality of wirings (300), wherein the width of the conductive adhesive is preferably in a range of 320 µm to 380 µm.

12. The solar cell module of any one preceding claim, wherein the conductive adhesive (200) has a form of a solder paste containing tin (Sn) or a form of a conductive adhesive paste in which a plurality of conductive particles (200P), which preferably include at least one of Ni, Ag, and SnBi, are distributed in an adhesive resin (200S), wherein the adhesive resin is preferably formed of at least one of an epoxy-based resin, a silicon-based resin, and an acrylic-based resin.

13. The solar cell module of claim 12, wherein the conductive particles (200P) have a size which is smaller than a width (W300K) or height (H300K) of each of the plurality of the wiring unevennesses (300K) and/or is between 1 µm and 10 µm.

14. The solar cell module of claim 12 or 13, wherein a melting point of the adhesive resin (200S) included in the conductive adhesive (200) is lower than a melting point of the conductive coating layer (320) included in the plurality of wirings (300).

15. The solar cell module of any one of claims 12 to 14, wherein a curing temperature of the adhesive resin (200S) is between 155 °C and 185 °C.

## Patentansprüche

1. Solarzellenmodul, umfassend:
eine Mehrzahl Solarzellen (C1, C2), die jeweils ein Halbleitersubstrat (110) und an einer Oberfläche des Halbleitersubstrats ausgebildete Elektroden (140, 150) beinhalten; und
eine Mehrzahl Verdrahtungen (300), die mit den in jeder Solarzelle bereitgestellten Elektroden durch ein leitfähiges Haftmittel (200) verbunden sind, um eine Mehrzahl benachbarter Solarzellen unter der Mehrzahl Solarzellen elektrisch zu verbinden, **dadurch gekennzeichnet, dass** jede der Mehrzahl Verdrahtungen ein Kernbündel (310) beinhaltet, das als ein Bündel aus einer Mehrzahl Kerne und einer leitfähigen Überzugsschicht (320) gebildet ist, die eine äußere Oberfläche des Kernbündels abdeckt, und
wobei eine Mehrzahl Verdrahtungsunebenheiten (300K) entlang einer Oberfläche jeder der Mehrzahl Verdrahtungen in einem äußeren Oberflächenmuster des Kernbündels ausgebildet ist.

2. Solarzellenmodul nach Anspruch 1, wobei die äußere Oberfläche des Kernbündels (310) mit einer durch die Mehrzahl Kerne gebildete Kernunebenheit (310K) versehen ist,
wobei die Kernunebenheit Ausnehmungen zwischen der Mehrzahl Kerne umfasst, und
wobei die Mehrzahl Verdrahtungsunebenheiten (300K) auf einer Oberfläche der leitfähigen Überzugsschicht (320) ausgebildet ist und Ausnehmungen zwischen der Mehrzahl Kerne umfasst.

3. Solarzellenmodul nach Anspruch 2, wobei eine maximale Dicke (MT320) der leitfähigen Überzugsschicht (320) kleiner als eine Höhe (H310K) oder als eine Breite (W310K) der Kernunebenheit (310K) ist und vorzugsweise zwischen 1/10 und 1/2 der Höhe der an der äußeren Oberfläche des Kernbündels (310) gebildeten Kernunebenheit beträgt.

4. Solarzellenmodul nach Anspruch 2 oder 3, wobei eine Linienbreite (R310) jeder der Mehrzahl Kerne, die die äußere Oberfläche des Kernbündels ausbilden, zwischen 70 µm und 160 µm beträgt, und
wobei eine durchschnittliche Dicke (T320) der leitfähigen Überzugsschicht (320) zwischen 5 µm und 20 µm beträgt.

5. Solarzellenmodul nach einem der vorhergehenden Ansprüche, wobei die Mehrzahl Kerne aus Kupfer (Cu) oder aus Silber (Ag) oder aus Gold (Au) oder aus Aluminium (Al) gebildet ist, und
wobei die leitfähige Überzugsschicht (320) aus Zinn (Sn) oder aus einer Zinn (Sn) enthaltenden Legierung gebildet ist.

6. Solarzellenmodul nach einem der vorhergehenden Ansprüche, wobei die Mehrzahl Verdrahtungsunebenheiten (300K) in jeder der Mehrzahl Verdrahtungen an einer Oberfläche eines ersten mit den Elektroden (140, 150) verbundenen Verdrahtungsteilbereichs (300P1) und an einer Oberfläche eines zweiten Verdrahtungsteilbereichs (300P2) gegenüber dem ersten Verdrahtungsteilbereich in Bezug auf eine Mitte der Mehrzahl Verdrahtungen (300) ausgebildet ist.

7. Solarzellenmodul nach Anspruch 6, wobei das Kernbündel (310) durch Stapeln der Mehrzahl Kerne in wenigstens drei Schichten ausgebildet ist, und
wobei die Anzahl der Mehrzahl auf dem ersten Verdrahtungsteilbereich (300P1) und dem zweiten Verdrahtungsteilbereich (300P2) gestapelter Kerne geringer als die Anzahl der Mehrzahl zwischen dem ersten Verdrahtungsteilbereich und dem zweiten Verdrahtungsteilbereich gestapelter Kerne ist.

8. Solarzellenmodul nach einem der vorhergehenden Ansprüche, wobei eine Breite (W300K) jeder der Mehrzahl an der Oberfläche jeder der Mehrzahl Verdrahtungen ausgebildeter Verdrahtungsunebenheiten (300K) zwischen 70 µm und 150 µm beträgt, und
wobei eine Höhe (H300K) jeder der Mehrzahl an der Oberfläche jeder der Mehrzahl Verdrahtungen ausgebildeter Verdrahtungsunebenheiten zwischen 10 µm und 70 µm beträgt.

9. Solarzellenmodul nach einem der vorhergehenden Ansprüche, wobei die Mehrzahl in dem Kernbündel (310) vorhandener Kerne in einer Längsrichtung der Mehrzahl Verdrahtungen (300) gestreckt oder verdreht ist; und/oder wobei es sich bei einem Querschnitt jedes der Mehrzahl Kerne um ein Kreismuster oder um ein elliptisches Muster oder um ein mehreckiges Muster mit einem kreisförmigen Umriss handelt.

10. Solarzellenmodul nach einem der vorhergehenden Ansprüche, wobei eine maximale Linienbreite jeder der Mehrzahl Verdrahtungen (300) zwischen 200 µm und 500 µm beträgt.

11. Solarzellenmodul nach einem der vorhergehenden Ansprüche, wobei eine Breite (W200) des leitfähigen Haftmittels (200) größer als eine Breite (W300K) jeder der Mehrzahl mit dem leitfähigen Haftmittel verbundener Verdrahtungsunebenheiten (300K) ist und kleiner als eine maximale Linienbreite jeder der Mehrzahl Verdrahtungen (300) ist, wobei die Breite des leitfähigen Haftmittels vorzugsweise in einem Bereich von 320 µm bis 380 µm liegt.

12. Solarzellenmodul nach einem der vorhergehenden Ansprüche, wobei das leitfähige Haftmittel (200) die Form einer Zinn (Sn) enthaltenden Lötpaste oder eine Form einer leitfähigen haftfähigen Paste aufweist, in der eine Mehrzahl leitfähiger Partikel (200P), die vorzugsweise wenigstens Ni und/oder Ag und/oder SnBi beinhalten, in einem haftfähigen Harz (200S) verteilt sind, wobei das haftfähige Harz vorzugsweise wenigstens aus einem epoxidbasierten Harz und/oder aus einem silikonbasierten Harz und/oder aus einem acrylbasierten Harz gebildet ist.

13. Solarzellenmodul nach Anspruch 12, wobei die leitfähigen Partikel (200P) eine Größe aufweisen, die kleiner als eine Breite (W300K) oder Höhe (H300K) jeder der Mehrzahl Verdrahtungsunebenheiten (300K) ist und/oder zwischen 1 µm und 10 µm beträgt.

14. Solarzellenmodul nach Anspruch 12 oder 13, wobei ein Schmelzpunkt des in dem leitfähigen Haftmittel (200) beinhalteten haftfähigen Harzes (200S) geringer als ein Schmelzpunkt der in der Mehrzahl Verdrahtungen (300) beinhalteten leitfähigen Überzugsschicht (320) ist.

15. Solarzellenmodul nach einem der Ansprüche 12 bis 14, wobei eine Aushärtungstemperatur des haftfähigen Harzes (200S) zwischen 155°C und 185°C beträgt.

## Revendications

1. Module de cellule solaire comprenant :
une pluralité de cellules solaires (C1, C2) comprenant chacune un substrat semi-conducteur (110) et des électrodes (140, 150) formées sur une surface du substrat semi-conducteur ; et
une pluralité de câblages (300) reliés aux électrodes prévues dans chaque cellule solaire par l'intermédiaire d'un adhésif conducteur (200) afin de relier électriquement une pluralité de cellules solaires adjacentes parmi la pluralité de cellules solaires,
**caractérisé par le fait que** chacun parmi la pluralité de câblages comprend un faisceau d'âmes (310) réalisé sous la forme d'un faisceau d'une pluralité d'âmes et une couche de revêtement conductrice (320) recouvrant une surface externe du faisceau d'âmes, et
une pluralité d'irrégularités de câblage (300K) étant formées le long d'une surface de chacun parmi la pluralité de câblages dans une forme de surface externe du faisceau d'âmes.

2. Module de cellule solaire selon la revendication 1, dans lequel la surface externe du faisceau d'âmes (310) comporte une irrégularité d'âme (310K) formée par la pluralité d'âmes,
l'irrégularité d'âme comprenant des renfoncements entre la pluralité d'âmes, et
la pluralité d'irrégularités de câblage (300K) étant formées sur une surface de la couche de revêtement conductrice (320) et comprenant des renfoncements entre la pluralité d'âmes.

3. Module de cellule solaire selon la revendication 2, dans lequel une épaisseur maximale (MT320) de la couche de revêtement conductrice (320) est plus petite qu'une hauteur (H310K) ou qu'une largeur (W310K) de l'irrégularité d'âme (310K), et est de préférence comprise entre 1/10 et 1/2 de la hauteur de l'irrégularité d'âme formée sur la surface externe de faisceau d'âmes (310).

4. Module de cellule solaire selon la revendication 2 ou 3, dans lequel une largeur de ligne (R310) de chacune parmi la pluralité d'âmes formant la surface externe du faisceau d'âmes est comprise entre 70 µm et 160 µm, et
une épaisseur moyenne (T320) de la couche de revêtement conductrice (320) est comprise entre 5 µm et 20 µm.

5. Module de cellule solaire selon l'une quelconque des revendications précédentes, dans lequel la pluralité d'âmes sont faites de l'un quelconque parmi le cuivre (Cu), l'argent (Ag), l'or (Au) et l'aluminium (Al), et
la couche de revêtement conductrice (320) est faite d'étain (Sn) ou d'un alliage contenant de l'étain (Sn).

6. Module de cellule solaire selon l'une quelconque des revendications précédentes, dans lequel la pluralité d'irrégularités de câblage (300K) sont formées sur une surface d'une première partie de câblage (300P1) reliée aux électrodes (140, 150), et sur une surface d'une seconde partie de câblage (300P2) opposée à la première partie de câblage par rapport à un centre de la pluralité de câblages (300) dans chacun parmi la pluralité de câblages.

7. Module de cellule solaire selon la revendication 6, dans lequel le faisceau d'âmes (310) est formé par empilement de la pluralité d'âmes en au moins trois couches, et
le nombre de la pluralité d'âmes empilées sur la première partie de câblage (300P1) et la seconde partie de câblage (300P2) étant inférieur au nombre de la pluralité d'âmes empilées entre la première partie de câblage et la seconde partie de câblage.

8. Module de cellule solaire selon l'une quelconque des revendications précédentes, dans lequel une largeur (W300K) de chacune parmi la pluralité d'irrégularités de câblage (300K) formées sur la surface de chacun parmi la pluralité de câblages est comprise entre 70 µm et 150 µm, et
une hauteur (H300K) de chacune parmi la pluralité d'irrégularités de câblage formées sur la surface de chacun parmi la pluralité de câblages est comprise entre 10 µm et 70 µm.

9. Module de cellule solaire selon l'une quelconque des revendications précédentes, dans lequel la pluralité d'âmes prévues dans le faisceau d'âmes (310) sont allongées ou torsadées dans une direction longitudinale de la pluralité de câblages (300) ; et/ou dans lequel une section transversale de chacune parmi la pluralité d'âmes est l'une parmi d'une forme circulaire, d'une forme elliptique et d'une forme polygonale ayant un contour circulaire.

10. Module de cellule solaire selon l'une quelconque des revendications précédentes, dans lequel une largeur de ligne maximale de chacun parmi la pluralité de câblages (300) est comprise entre 200 µm et 500 µm.

11. Module de cellule solaire selon l'une quelconque des revendications précédentes, dans lequel une largeur (W200) de l'adhésif conducteur (200) est plus grande qu'une largeur (W300K) de chacune parmi la pluralité d'irrégularités de câblage (300K) reliées à l'adhésif conducteur, et plus petite qu'une largeur de ligne maximale de chacun parmi la pluralité de câblages (300), la largeur de l'adhésif conducteur étant de préférence comprise dans une plage allant de 320 µm à 380 µm.

12. Module de cellule solaire selon l'une quelconque des revendications précédentes, dans lequel l'adhésif conducteur (200) a une forme d'une pâte de soudure contenant de l'étain (Sn) ou une forme d'une pâte d'adhésif conducteur dans laquelle une pluralité de particules conductrices (200P), qui comprennent de préférence au moins un parmi Ni, Ag et SnBi, sont réparties dans une résine adhésive (200S), la résine adhésive étant de préférence faite d'au moins une parmi une résine à base d'époxy, une résine à base de silicone et une résine acrylique.

13. Module de cellule solaire selon la revendication 12, dans lequel les particules conductrices (200P) ont une taille qui est plus petite qu'une largeur (W300K) ou qu'une hauteur (H300K) de chacune parmi la pluralité d'irrégularités de câblage (300K) et/ou est comprise entre 1 µm et 10 µm.

14. Module de cellule solaire selon la revendication 12 ou 13, dans lequel un point de fusion de la résine adhésive (200S) comprise dans l'adhésif conducteur (200) est inférieur à un point de fusion de la couche de revêtement conductrice (320) comprise dans la pluralité de câblages (300).

15. Module de cellule solaire selon l'une quelconque des revendications 12 à 14, dans lequel une température de prise de la résine adhésive (200S) est comprise entre 155°C et 185°C.
